# EUROPEAN PATENT APPLICATION

(11) **EP 4 585 938 A1**
(43) Date of publication of application: **16.07.2025**
(21) Application number: 24151445.4
(22) Date of filing: 11.01.2024
(51) Int. Cl.: G01R 31/327, G01R 31/40, G01R 31/56, H02M 1/32, H03K 17/18

(54) **FAULT DETECTION**

(71) Applicant: Thermo King LLC, Minneapolis, MN 55420 (US)
(72) Inventor: Gorski, Matthias, 44866 Bochum (DE); Bock, Sebastian, 45239 Essen (DE)
(74) Representative: Haseltine Lake Kempner LLP

(57) **Abstract**

A fault detection system for detecting a fault in a switch of a half-bridge of a circuit in a transport refrigeration system (150), the fault detection system comprising: a voltage divider; and processor circuitry, wherein: in use of the fault detection system, the voltage divider is coupled in parallel with a switch of a half-bridge of the circuit; and an output of the voltage divider is coupled to an input of the processor circuitry, and wherein the processor circuitry is operative to: compare a detection signal indicative of a voltage at the output of the voltage divider to a reference signal; and responsive to a determination that the detection signal does not correspond to the reference signal, output a fault detection signal.

## Description

### Field of the Invention

The present disclosure relates to a fault detection system and method for detecting a fault in a switch such as a power semi-conductor of a half-bridge of a circuit such as an inverter in a transport refrigeration system.

### Background

A transport climate control system is generally used to control one or more environmental conditions such as temperature, humidity, air quality, or combinations thereof, of a transport unit. Examples of transport units include, but are not limited to a truck, a container (such as a container on a flat car, an intermodal container, a marine container, a rail container, etc.), a box car, a semi-tractor, a bus, or other similar transport unit. A transport climate control system may be integrated into the transport unit, or may be provided as a separate transport climate control unit (CCU), which may also be referred to as a transport refrigeration unit (TRU) that can be mounted or coupled to the transport unit.

A transport climate control system typically includes (among other elements) temperature control components such as compressors, pumps, fans, heat exchangers and the like, together with associated electrical elements such as sensors (e.g. temperature sensors), a controller, a display unit, electrical drives, electrical filters and the like. The temperature control components and associated elements are typically electrically powered.

The transport climate control system may be configured to receive electrical power from the transport unit. For example, the transport climate control system may be configured to receive electrical power from a prime mover of the transport unit (e.g. an engine of a truck, tractor unit or the like), from a battery of the transport unit (e.g. a battery of a truck, tractor unit or the like), and/or from a utility power or "shore power" source such as an electricity grid or network to which the transport unit can be coupled to receive mains electricity.

A transport climate control system may include components configured to run on direct current (DC) electrical power and components configured to run on single-phase or three-phase alternating current (AC) electrical power. For example, a transport climate control system may include a DC pump and one or more DC fans or blowers, and a compressor that is driven by a single phase or three phase AC motor. To accommodate the different power requirements of its components, a transport climate control system typically includes a DC bus or DC link which receives electrical power from a DC source such as a battery. DC components may be coupled to the DC bus or link (via suitable DC-DC converters, if necessary). One or more inverters may also be coupled to the DC bus or DC link to convert direct current (DC) electrical power into single phase and/or three phase AC electrical power suitable for powering AC components.

### Summary

According to a first aspect, the invention provides a fault detection system for detecting a fault in a switch of a half-bridge of a circuit in a transport refrigeration system, the fault detection system comprising: a voltage divider; and processor circuitry, wherein: in use of the fault detection system, the voltage divider is coupled in parallel with a switch of a half-bridge of the circuit; and an output of the voltage divider is coupled to an input of the processor circuitry, and wherein the processor circuitry is operative to: compare a detection signal indicative of a voltage at the output of the voltage divider to a reference signal; and responsive to a determination that the detection signal does not correspond to the reference signal, output a fault detection signal.

In use of the fault detection system, the voltage divider may be coupled in parallel with a low-side switch of a half-bridge of the circuit.

The voltage divider may be a resistive voltage divider comprising a first resistance connected in series with a second resistance.

The first resistance may comprise a plurality of resistors connected in series. The second resistance may comprise a single resistor.

The plurality of resistors of the first resistance and the single resistor of the second resistance may be surface mount devices, for example.

The voltage divider may be configured to receive an input DC voltage in the range 0 - 900 volts and to output an output DC voltage in the range 0 - 5 volts.

The voltage divider may be configured such that a magnitude of the output DC voltage is approximately 1/300th of a magnitude of the input DC voltage.

The fault may be an always-on fault.

The processor circuitry may be operative to: compare the detection signal indicative of the voltage at the output of the voltage divider to a first reference signal; and responsive to a determination that the detection signal is less than the first reference signal, output a first fault detection signal indicative of an always-on fault in a low-side switch of the circuit.

The processor circuitry may be operative to: compare the detection signal indicative of the voltage at the output of the voltage divider to a second reference signal; and responsive to a determination that the detection signal is greater than the second reference signal, output a second fault detection signal indicative of an always-on fault in a high-side switch of the circuit.

The circuit may be an inverter circuit or a multi level converter circuit, for example.

According to a second aspect, the invention provides a method for detecting a fault in a switch of a half-bridge of a circuit in a transport refrigeration unit, the method comprising: comparing, by processor circuitry, a signal indicative of an output voltage of a voltage divider coupled in parallel with a switch of a half-bridge of the inverter to a reference voltage; and responsive to a determination by the processor circuitry that the detected voltage does not correspond to the reference voltage, indicating a fault condition.

According to a third aspect, the invention provides a transport refrigeration system comprising a circuit and a fault detection system according to the first aspect.

According to a fourth aspect, the invention provides a machine-readable medium having stored thereon a computer program comprising instructions which, when executed by processing means, cause the processing means to perform the method of the second aspect.

Throughout this specification the word "comprise", or variations such as "comprises" or "comprising", will be understood to imply the inclusion of a stated element, integer or step, or group of elements, integers or steps, but not the exclusion of any other element, integer or step, or group of elements, integers or steps.

### Brief Description of Drawings

Embodiments of the invention will now be described, strictly by way of example only, with reference to the accompanying drawings, of which:
Figure 1 shows a vehicle comprising a transport refrigeration system;
Figure 2 is an exemplary schematic diagram showing a three-phase inverter coupled to a DC link to convert input DC electrical power into three-phase AC electrical power;
Figure 3 is a schematic diagram showing a fault detection system according to the present disclosure, which in the example shown is coupled to a half-bridge of three-phase inverter;
Figure 4 is a schematic diagram showing an example arrangement of a voltage divider and an example arrangement of a balancing impedance of the fault detection system of Figure 3;
Figure 5 is a flow diagram showing processing operations performed by processor circuitry in a method for detecting a fault using the fault detection system of Figure 3; and
Figure 6 is a schematic representation of a machine-readable medium having stored thereon a computer program comprising instructions which, when executed by suitable processing means, cause the processing means 620 to perform the steps of the method of Figure 5.

### Detailed Description

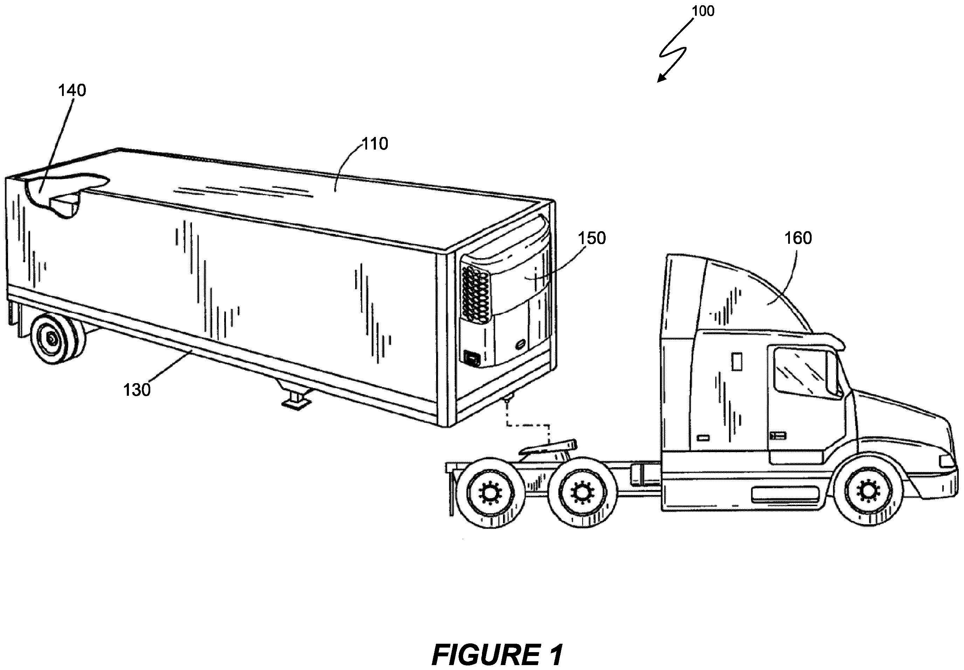

**Figure** 1 shows a vehicle 100 comprising a transport refrigeration system 110. In the example of FIG. 1, the transport refrigeration system 110 forms a part of an over-the-road refrigerated semi-trailer having a structure 130 supporting (or forming) at least one climate-controlled compartment 140 which is configured to be cooled and/or heated by a TRU 150. The climate-controlled compartment 140 can take the form of multiple compartments or have multiple zones. The structure 130 includes a chassis. The structure 130 supports the TRU 150. The vehicle 100 further comprises a tractor unit 160 removably couplable to the trailer.

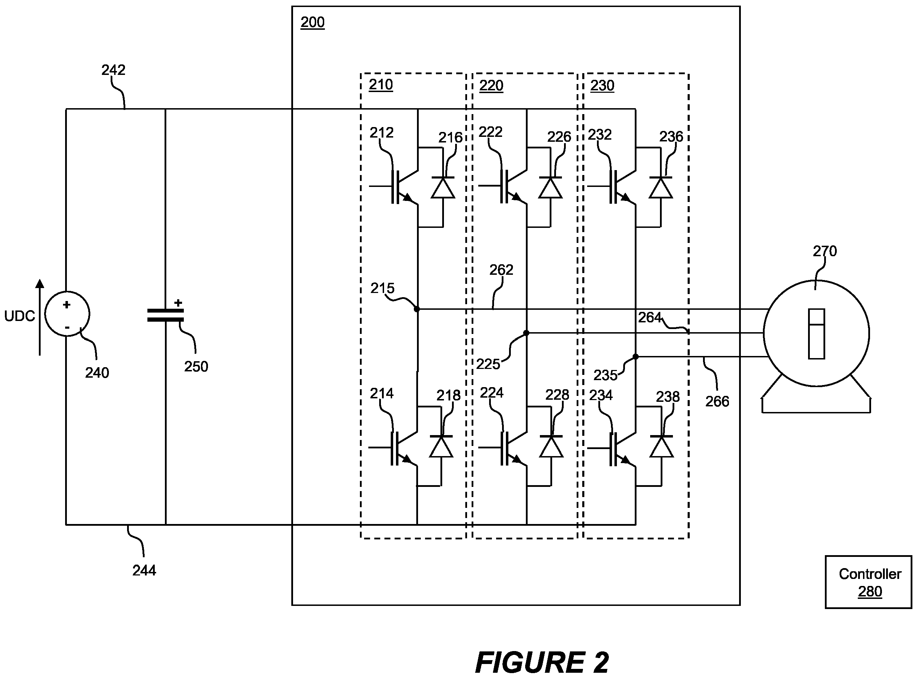

**Figure 2** is a schematic diagram showing a three-phase inverter coupled to a DC link to convert input DC electrical power into three-phase AC electrical power for powering a load such as a three-phase motor that drives a compressor, for example.

The three-phase inverter, shown generally at 200 in Figure 2, comprises a first half-bridge 210, a second half-bridge 220 and a third half-bridge 230.

The first half-bridge 210 includes a first (high-side) switch 212, connected in series with a second (low-side) switch 214. In this example the first and second switches 212, 214 are insulated gate bipolar transistors (IGBTs), but it will be appreciated by those skilled in the art that other semiconductor switching devices (in particular power semiconductor switching devices) may also be used.

A first freewheel diode 216 is connected in an inverse parallel configuration with the first switch 212, with its anode connected to an emitter of the first switch 212 and its cathode connected to a collector of the first switch 212. A second freewheel diode 218 is connected in an inverse parallel configuration with the second switch 214, with its anode connected to an emitter of the second switch 214 and its cathode connected to a collector of the second switch 214.

The emitter of the first switch 212 is connected to the collector of the second switch 214. The collector of the first switch 212 is connected to positive rail 242 of a DC link 240, which in turn is connected to a first terminal of a DC link capacitor 250. The emitter of the second switch 214 is connected to a ground rail 244 of the DC link 240, which in turn is connected to a second terminal of the DC link capacitor 250.

A node 215 between the first and second switches 212, 214 is coupled, in this example, via a first phase output path 262, to a first input of a three-phase motor 270.

The gates of the first and second switches 212, 214 are connected, via suitable gate drive circuitry (as will be familiar to those skilled in the art) to outputs of a controller 280, which is configured to generate control signals to switch the first and second switches 212, 214 on and off in a predetermined sequence to convert a DC input voltage at the DC link 240 to a first phase of a three-phase AC output voltage at the first phase output path 262.

Thus, when the first switch 212 is switched on (in response to an appropriate control signal from the controller 280), the first phase output path 262 is coupled to the positive rail 242 of the DC link 240. When the second switch 214 is switched on (in response to an appropriate control signal from the controller 280), the first phase output path 262 is coupled to the ground rail 244 of the DC link 240.

The second half-bridge 220 is of a similar construction as the first half-bridge 210, and comprises first (high-side) and second (low-side) switches 222, 224 (which in this example are IGBTs) and first and second freewheel diodes 226, 228, which are connected in the same manner as the first and second switches 212, 214 and the first and second freewheel diodes 216, 218 of the first half-bridge 210. A node 225 between the first and second switches 222, 224 is coupled, via a second phase output path 264, to a second input of the three-phase motor 270.

The gates of the first and second switches 222, 224 are connected to outputs of the controller 280, which is configured to generate control signals to switch the first and second switches 222, 224 on and off in a predetermined sequence to convert the DC input voltage at the DC link 240 to a second phase of a three-phase AC output voltage at the second phase output path 264, as described above with respect to the first half-bridge 210.

The third half-bridge 230 is of a similar construction as the first and second half-bridges 210, 220, and comprises first (high-side) and second (low-side) switches 232, 234 (which in this example are IGBTs) and first and second freewheel diodes 236, 238, which are connected in the same manner as the first and second switches 212, 214 and the first and second freewheel diodes 216, 218 of the first half-bridge 210. A node 235 between the first and second switches 232, 234 is coupled, via a third phase output path 266, to a third input of the three-phase motor 270.

The gates of the first and second switches 232, 234 are connected to outputs of the controller 280, which is configured to generate control signals to switch the first and second switches 232, 234 on and off in a predetermined sequence to convert the DC input voltage at the DC link 240 to a third phase of a three-phase AC output voltage at the third phase output path 266, as described above with respect to the first half-bridge 210.

It is important that the first and second switches of any half-bridge are not switched on at the same time, as this would lead to a short circuit between the positive and ground rails 242, 244 of the DC link 240, which could give rise to a very high "shoot-through" current as the DC link capacitor 250 discharges rapidly through the first and second switches. This high current could damage or destroy the switches, thus necessitating their replacement, which may be time consuming and costly.

Thus the controller 280 is configured to control the timing of control signals to the first and second switches of each half-bridge 210, 220, 230 to ensure complementary operation of the first and second switches (i.e. when the first switch 212, 222, 232 is switched on, the second switch 214, 224, 234 is switched off, and vice-versa). However, it is possible that one or more of the switches 212, 214, 222, 224, 232, 234 may develop a fault (sometimes referred to as an "always-on" fault) that causes the switch to remain switched on even when no control signal, or when a control signal that should have the effect of turning the switch off, is being supplied to its gate.

The present disclosure provides a fault detection system and method for detecting a fault in a switch of a half-bridge of an inverter.

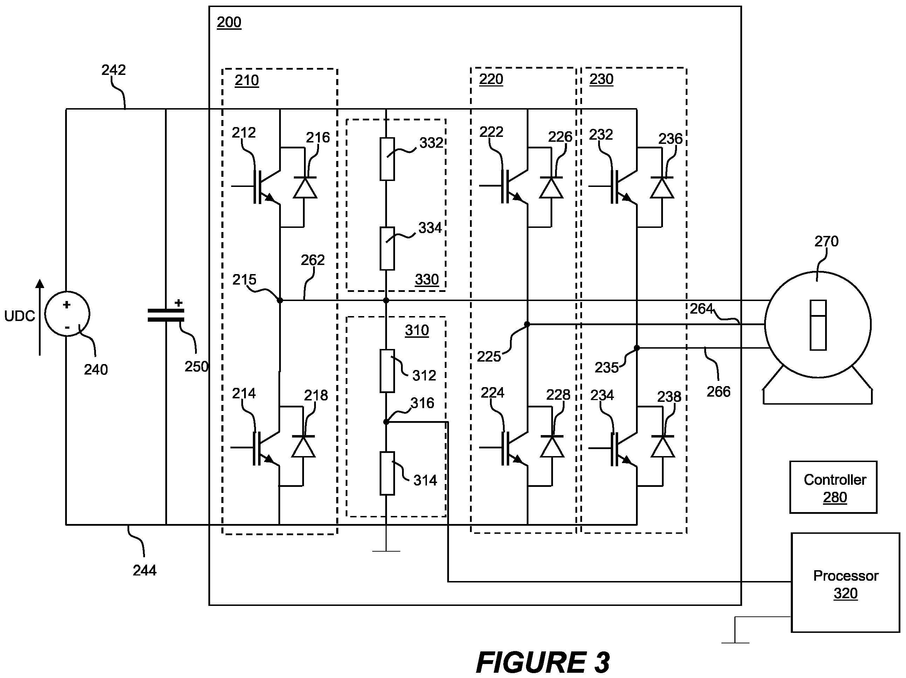

**Figure** 3 is a schematic diagram showing a fault detection system according to the present disclosure coupled to a three-phase inverter. Figure 3 has a number of elements in common with Figure 2. Such common elements are denoted by common reference numerals in Figures 2 and 3 and will not be described again in detail here, for the sake of brevity and clarity.

The fault detection system includes a voltage divider 310 and processor circuitry 320. In the example illustrated in Figure 3 the voltage divider 310 comprises first and second resistances 312, 314 coupled in series, and a voltage divider output node 316 between the first and second resistances 312, 314 is coupled to an input of the processor circuitry 320. However, it will be appreciated by those skilled in the art that the voltage divider 310 could have a different configuration. For example, the voltage divider 310 may be a capacitive voltage divider rather than a resistive voltage divider as shown in Figure 3. Further, although the voltage divider output node 316 is shown as being directly coupled to the input of the processor circuitry 320, it will be appreciated that in a practical implementation of the fault detection system the voltage divider output node 316 may be indirectly coupled to the input of the processor circuitry 320 via one or more intermediate components or circuits such as an analogue to digital converter (ADC) and/or a filter.

The processor circuitry 320 may comprise a microprocessor, microcontroller, state machine or the like, or may comprise discrete circuitry or integrated circuitry configured to perform the processing functions and operations described below. In some examples the controller 280 may comprise the processor circuitry 320, or may be configured to perform the processing functions and operations of the processor circuitry 320.

In the example illustrated in Figure 3, the voltage divider 310 is coupled in parallel with the second (low-side) switch of the first half-bridge 210. Thus, a first terminal of the voltage divider 310 is coupled to the node 215 between the first and second switches 212, 214 of the first half-bridge 210 and a second terminal of the voltage divider 310 is coupled to the ground rail 244 of the DC link 240.

The fault detection system further includes a balancing impedance 330, which is coupled in parallel with the first switch 212 of the first half-bridge 210. Thus, a first terminal of the balancing impedance 330 is coupled to the positive rail 242 of the DC link 240 and a second terminal of the balancing impedance 330 is coupled to the node 215 between the first and second switches 212, 214 of the first half-bridge 210. The purpose of the balancing impedance 330 is to balance the total impedance of the voltage divider 310. In the example illustrated in Figure 3 the balancing impedance 330 comprises a first resistance 332, of equal resistance to the first resistance 312 of the voltage divider 310, coupled in series with a second resistance 334, of equal resistance to the second resistance 314 of the voltage divider 310, such that the total resistance of the balancing impedance 330 is equal to the total resistance of the voltage divider 310. However, it will be appreciated that the balancing impedance 330 could be implemented using a single resistance of equal resistance to the total resistance of the voltage divider 310. Further, if the voltage divider 310 is not a resistive voltage divider, the balancing impedance 330 may be implemented using components other than resistances. For example, if the voltage divider 310 is a capacitive voltage divider, the balancing impedance may be implemented using one or more capacitors (or other capacitive components).

When the inverter 200 is coupled to the DC link 240 and none of the switches 212, 214, 222, 224, 232, 234 is switched on (e.g. when the inverter 200 is not active), the resistance (i.e. the off-resistance) of each switch 212, 214, 222, 224, 232, 234 is in the mega-ohms range. The off-resistance of the first switch 212 of the first half-bridge 210 is approximately equal to the off-resistance of the second switch 214 of the first half-bridge 210. Thus, in the absence of any faults in the first or second switches 212, 214, a voltage at the node 215, which is equal to a phase voltage Um of the first phase output path 262 is approximately equal to half of the DC link voltage UDC, i.e. Um ≈ UDC/2.

In the event of an "always-on" fault in the first (high-side) switch 212, the off-resistance of the first switch 212 will be close to zero, such that the voltage at the node 215, and thus the phase voltage Um of the first phase output path 262 is approximately equal to the DC link voltage UDC, i.e. Um ≈ UDC.

In the event of an "always-on" fault in the second (low-side) switch 214, the off-resistance of the second switch 214 will be close to zero, such that the voltage at the node 215, and thus the phase voltage Um of the first phase output path 262 is approximately equal to zero, i.e. Um ≈ 0.

The fault detection system of the present disclosure is able to detect such faults by monitoring a voltage divider output voltage at the voltage divider output node 316, which is indicative of the voltage at the node 215. If the monitored voltage divider output voltage does not correspond to an expected voltage, the fault detection system can output a fault detection signal to cause appropriate action to be taken in response to detection of the fault. For example, the fault detection circuitry may output a fault detection signal to the controller 280. Responsive to a fault detection signal indicative of an always-on fault in the second switch 214, the controller 280 may output a control signal to turn the first switch 212 off, thus preventing the possibility of a short circuit between the positive and ground rails 242, 244 of the DC link.

The DC link 240 may supply a high DC link voltage UDC, e.g. of the order of 800 - 900v DC, such that the voltage at the node 215 may be in the range 0 - 800 or 900v DC. In contrast, the processor circuitry 320 may be configured to receive low voltage DC inputs, e.g. in the range 0 - 5v DC. The voltage divider 310 is thus configured to generate the voltage divider output voltage from the voltage at the node 215 such that a level of the voltage divider output voltage is suitable for input (directly or indirectly) to the processor circuitry 320.

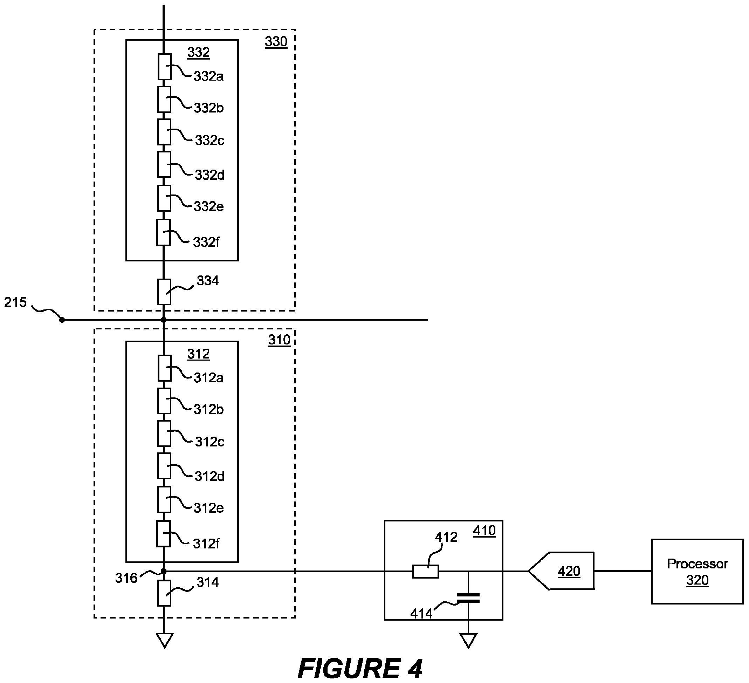

**Figure 4** is a schematic diagram showing an example arrangement of the voltage divider 310 and an example arrangement of the balancing impedance 300.

In the example shown in Figure 4, the first resistance 312 of the voltage divider 310 comprises a string of six resistors 132a - 312f of resistance 75kΩ connected in series, such that the value of the first resistance 312 is 450kΩ. The second resistance 314 of the voltage divider 310 comprises a single resistor of resistance 1.5kΩ. Thus, the total resistance of the voltage divider 310 in the illustrated example is 451.5 kΩ, and the voltage divider output voltage at the voltage divider output node 316 is equal to 15/4510 (approximately 1/300^{th}) of the voltage at the node 215.

Thus, when the inverter 200 is coupled to the DC link 240 but is not active (i.e. none of the switches 212, 214, 222, 224, 232, 234 is switched on), if the DC link voltage UDC is 900V, then in the event of an always-on fault in the second switch 214 the voltage divider output voltage is approximately 0v, whereas in the event of an always-on fault in the first switch 212, the voltage divider output voltage is approximately 3v.

In the example shown in Figure 4, the balancing impedance 330 has the same structure and configuration as the voltage divider 310. Thus, the first resistance 332 of the balancing impedance 330 comprises a string of six resistors 332a - 332f of resistance 75kΩ connected in series, such that the value of the first resistance is 450kΩ, and the second resistance 334 of the balancing impedance 330 comprises a single resistor of resistance 1.5kΩ. Thus, the total resistance of the balancing impedance 330 is 451.5kΩ, equal to the total resistance of the voltage divider 310.

The resistors 312a - 312f and 314 of the voltage divider 310 and the resistors 332a - 332f and 324 of the balancing impedance 330 may be, for example, surface mount resistors (also referred to as surface mount devices or SMDs). Such resistors are small and inexpensive, and thus provide a spatially efficient and cost-effective way to implement the voltage divider 310 and the balancing impedance 330.

As noted above, the voltage divider output node 316 may be indirectly coupled to the input of the processor circuitry 320 via one or more intermediate components or circuits such as an analogue to digital converter (ADC) and/or a filter. Figure 4 shows an example of such an arrangement, in which an input of a filter 410 (comprising a resistor 412 and a capacitor 414) is coupled to the voltage divider output node 316. The filter 410 is operative to filter the voltage divider output voltage, e.g. to remove or attenuate high-frequency components of the voltage divider output voltage. An output of the filter 410 is coupled to an input of an ADC 420. The ADC 420 is configured to convert the filtered voltage divider output voltage into a digital signal indicative of the voltage divider output voltage, which can be output (via an output of the ADC 420) to the input of the processor circuitry 320. It will be appreciated by those skilled in the art, however, that other arrangements for coupling the voltage divider output node 316 to the input of the processor circuitry 320 are also possible.

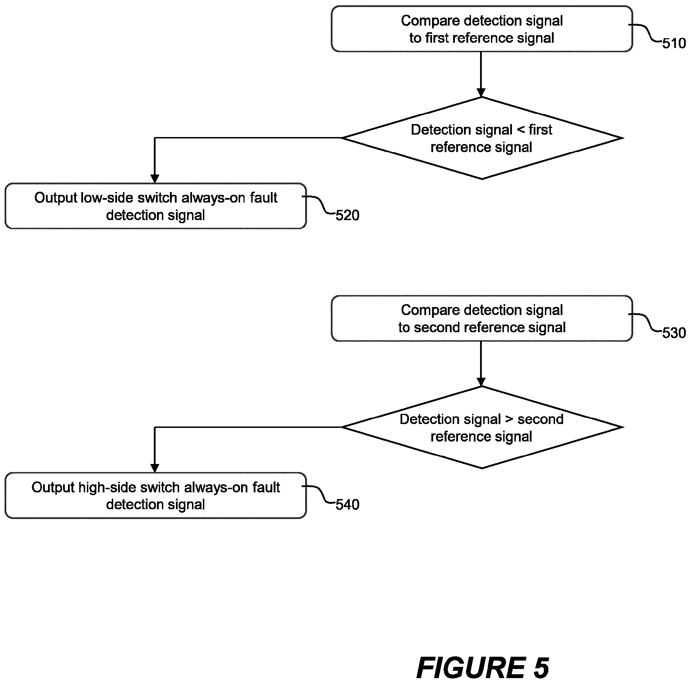

**Figure 5** is a flow diagram showing processing operations performed by the processor circuitry 320 in a method for detecting a fault using the fault detection system described above with reference to Figure 3.

The processor circuitry 320 compares a detection signal indicative of the voltage divider output voltage (which may be the voltage divider output voltage, or may be, for example, a digital signal indicative of the voltage divider output voltage) to one or more predefined reference signals (e.g. one or more predefined reference voltages or digital signals indicative of predefined reference voltages). If the processor circuitry 320 determines that the detection signal does not correspond to the predefined reference signal(s), the processor circuitry 320 outputs a fault detection signal.

For example, the processor circuitry 320 may, at step 510 of Figure 5, compare the detection signal to a first reference signal indicative of a first, low, reference voltage. The first reference voltage may be of the order of 0.1v DC, for example.

If the detection signal is less than the first reference signal, this may be indicative of an always-on fault in the second (low-side) switch 214, and the processor circuitry 320 may thus, at step 520, output (e.g. to the controller) a fault detection signal indicating detection of an always-on fault in the second (low-side) switch 214.

Responsive to this fault detection signal, the controller 280 may take appropriate action such as outputting a control signal to turn the first switch 212 off and maintain the first switch 212 in a switched off condition, to prevent the possibility of a short circuit between the positive rail 242 and the ground rail 244 of the DC link 240.

Additionally or alternatively, the processor circuitry 320 may, at step 530 of Figure 5, compare the detection signal to a second reference signal indicative of a second, relatively high, reference voltage. The second reference voltage may be of the order of 2.8v DC, for example.

If the detection signal is greater than the second reference signal, this may be indicative of an always-on fault in the first (high-side) switch 212, and the processor circuitry 320 may thus, at step 540, output (e.g. to the controller) a fault detection signal indicating detection of an always-on fault in the first (high-side) switch 212.

Responsive to this fault detection signal, the controller 280 may take appropriate action such as outputting a control signal to turn the second switch 214 off and maintain the second switch 214 in a switched off condition, to prevent the possibility of a short circuit between the positive rail 242 and the ground rail 244 of the DC link 240.

As will be appreciated from the foregoing description, the fault detection system of the present disclosure provides a simple, reliable and cost-effective means for detecting a fault in a switch of a half bridge of an inverter to protect the inverter from damage resulting from shoot-through currents arising as a result of such switch faults.

If, as in the example shown in Figure 3, a three-phase motor 270 is coupled to the outputs of the inverter 200, only a single fault detection system of the kind described above is required to detect an always-on fault in any of the switches 212, 214, 222, 224, 232, 234 of the inverter 200, because the three half-bridges 210, 220, 230 are connected via a star or delta connection of the motor 270. More generally, if the load coupled to the outputs of the inverter 200 has a low DC impedance, e.g. if the load comprises three chokes connected in a star configuration with a star point, only a single fault detection system of the kind described above is required to detect an always-on fault in any of the switches 212, 214, 222, 224, 232, 234 of the inverter 200.

If a load that does not have a low DC impedance is coupled to the outputs of the inverter 200, it may be necessary to provide a fault detection system for each half-bridge 210, 220, 230, by coupling a separate voltage divider 310 in parallel with the second (low-side) switch 214, 224, 234 of each half-bridge 210, 220, 230. A separate instance of processor circuitry 320 may be provided for each of these separate voltage dividers, or alternatively a single instance of processor circuitry 320 may be provided, with the output node of each separate voltage divider 310 being coupled (directly or indirectly, as described above) to a respective different input of the processor circuitry 310.

In the foregoing description the fault detection system has been described in the context of a three-phase inverter, but it will be readily apparent to those skilled in the art that the fault detection system of the present disclosure is equally applicable to single-phase inverters. More generally, the fault detection system of the present disclosure is applicable to any circuit topology that uses one or more half-bridges, e.g. a multi-level converter such as a modular multi-level converter (MMC). Thus, the application of the fault detection system of the present disclosure is not limited to inverters, but is also applicable to any circuit that uses one or more half-bridges.

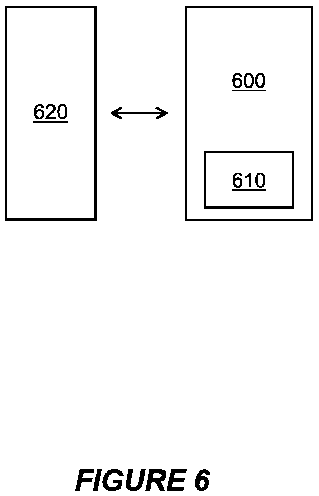

**Figure 6** shows, highly schematically, a machine-readable medium 600 having stored thereon a computer program 610 comprising instructions which, when executed by suitable processing means 620 (e.g. the processor circuitry 320), cause the processing means 620 to perform the steps of the above-described method.

Except where mutually exclusive, a feature described in relation to any one of the above aspects may be applied mutatis mutandis to any other aspect. Furthermore, except where mutually exclusive, any feature described herein may be applied to any aspect and/or combined with any other feature described herein. Moreover, while the present disclosure is made with in the context of transport refrigeration systems and/or vapour-compression circuits, it will be appreciated that the present disclosure has other possible applications in other technical areas.

This disclosure encompasses all changes, substitutions, variations, alterations, and modifications to the example embodiments herein that a person having ordinary skill in the art would comprehend. Similarly, where appropriate, the appended claims encompass all changes, substitutions, variations, alterations, and modifications to the example embodiments herein that a person having ordinary skill in the art would comprehend. Moreover, reference in the appended claims to an apparatus or system or a component of an apparatus or system being adapted to, arranged to, capable of, configured to, enabled to, operable to, or operative to perform a particular function encompasses that apparatus, system, or component, whether or not it or that particular function is activated, turned on, or unlocked, as long as that apparatus, system, or component is so adapted, arranged, capable, configured, enabled, operable, or operative. Accordingly, modifications, additions, or omissions may be made to the systems, apparatuses, and methods described herein without departing from the scope of the disclosure. For example, the components of the systems and apparatuses may be integrated or separated. Moreover, the operations of the systems and apparatuses disclosed herein may be performed by more, fewer, or other components and the methods described may include more, fewer, or other steps. Additionally, steps may be performed in any suitable order. As used in this document, "each" refers to each member of a set or each member of a subset of a set.

Although exemplary embodiments are illustrated in the figures and described below, the principles of the present disclosure may be implemented using any number of techniques, whether currently known or not. The present disclosure should in no way be limited to the exemplary implementations and techniques illustrated in the drawings and described above.

Unless otherwise specifically noted, articles depicted in the drawings are not necessarily drawn to scale.

All examples and conditional language recited herein are intended for pedagogical objects to aid the reader in understanding the disclosure and the concepts contributed by the inventor to furthering the art and are construed as being without limitation to such specifically recited examples and conditions. Although embodiments of the present disclosure have been described in detail, it should be understood that various changes, substitutions, and alterations could be made hereto without departing from the spirit and scope of the disclosure.

Although specific advantages have been enumerated above, various embodiments may include some, none, or all of the enumerated advantages. Additionally, other technical advantages may become readily apparent to one of ordinary skill in the art after review of the foregoing figures and description.

It should be noted that the above-mentioned embodiments illustrate rather than limit the invention, and that those skilled in the art will be able to design many alternative embodiments without departing from the scope of the appended claims. The word "comprising" does not exclude the presence of elements or steps other than those listed in a claim, "a" or "an" does not exclude a plurality, and a single feature or other unit may fulfil the functions of several units recited in the claims. Any reference numerals or labels in the claims shall not be construed so as to limit their scope.

## Claims

1. A fault detection system for detecting a fault in a switch (212, 214, 222, 224, 232, 234) of a half-bridge of a circuit (200) in a transport refrigeration system (150), the fault detection system comprising:
a voltage divider (310); and
processor circuitry (320),
wherein:
in use of the fault detection system, the voltage divider (310) is coupled in parallel with a switch (214, 224, 234) of a half-bridge (210, 220, 230) of the circuit (200); and
an output (316) of the voltage divider (310) is coupled to an input of the processor circuitry (320),
and wherein the processor circuitry (320) is operative to:
compare (510) a detection signal indicative of a voltage at the output (316) of the voltage divider (310) to a reference signal; and
responsive to a determination that the detection signal does not correspond to the reference signal, output (520, 540) a fault detection signal.

2. A fault detection system according to claim 1, wherein, in use of the fault detection system, the voltage divider (310) is coupled in parallel with a low-side switch (214, 224, 234) of a half-bridge (210, 220, 230) of the circuit (200).

3. A fault detection system according to claim 1 or claim 2, wherein the voltage divider (310) is a resistive voltage divider comprising a first resistance (312) connected in series with a second resistance (314).

4. A fault detection system according to claim 3, wherein:
the first resistance (312) comprises a plurality of resistors (312a - 312f) connected in series, and
the second resistance (314) comprises a single resistor.

5. A fault detection system according to claim 4, wherein the plurality of resistors (312a - 312f) of the first resistance (312) and the single resistor of the second resistance (314) are surface mount devices.

6. A fault detection system according to any of the preceding claims, wherein the voltage divider (310) is configured to receive an input DC voltage in the range 0 - 900 volts and to output an output DC voltage in the range 0-5 volts.

7. A fault detection system according to claim 6, wherein the voltage divider (310) is configured such that a magnitude of the output DC voltage is approximately 1/300^{th} of a magnitude of the input DC voltage.

8. A fault detection system according to any of the preceding claims, wherein the fault is an always-on fault.

9. A fault detection system according to any of the preceding claims, wherein the processor circuitry (320) is operative to:
compare (510) the detection signal indicative of the voltage at the output (316) of the voltage divider (310) to a first reference signal; and
responsive to a determination that the detection signal is less than the first reference signal, output (520) a first fault detection signal indicative of an always-on fault in a low-side switch of the circuit (200).

10. A fault detection system according to any of the preceding claims, wherein the processor circuitry (320) is operative to:
compare (530) the detection signal indicative of the voltage at the output (316) of the voltage divider (310) to a second reference signal; and
responsive to a determination that the detection signal is greater than the second reference signal, output (540) a second fault detection signal indicative of an always-on fault in a high-side switch of the circuit (200).

11. A fault detection system according to any of the preceding claims, wherein the circuit is an inverter circuit or a multi level converter circuit.

12. A method for detecting a fault in a switch of a half-bridge of a circuit in a transport refrigeration unit, the method comprising:
comparing (510, 530), by processor circuitry, a signal indicative of an output voltage of a voltage divider coupled in parallel with a switch of a half-bridge of the inverter to a reference voltage; and
responsive to a determination by the processor circuitry that the detected voltage does not correspond to the reference voltage, indicating (520, 540) a fault condition.

13. A transport refrigeration system (150) comprising a circuit (200) and a fault detection system according to any of claims 1-11.

14. A machine-readable medium (600) having stored thereon a computer program comprising instructions which, when executed by processing means, cause the processing means to perform the method of claim 12.

## Amended claims

### Amended claims in accordance with Rule 137(2) EPC.

1. A fault detection system for detecting a fault in a switch (212, 214, 222, 224, 232, 234) of a half-bridge of a circuit (200) in a transport refrigeration system (150), the fault detection system comprising:
a voltage divider (310);
a balancing impedance (330); and
processor circuitry (320),
wherein:
in use of the fault detection system: the balancing impedance (330) is coupled in parallel with a first switch (212, 222, 232) of a half-bridge (210, 220, 230) of the circuit (200); and the voltage divider (310) is coupled in parallel with a second switch (214, 224, 234) of the half-bridge (210, 220, 230) of the circuit (200), wherein an output (316) of the voltage divider (310) is indicative of a voltage of a node (215) between the first switch (212, 222, 232) of the half-bridge and the second switch (214, 224, 234) of the half-bridge;
and
an output (316) of the voltage divider (310) is coupled to an input of the processor circuitry (320),
and wherein the processor circuitry (320) is operative to:
compare (510) a detection signal indicative of a voltage at the output (316) of the voltage divider (310) to a reference signal; and
responsive to a determination that the detection signal does not correspond to the reference signal, output (520, 540) a fault detection signal;
wherein the balancing impedance (330) is configured to balance the total impedance of the voltage divider (310).

2. A fault detection system according to claim 1, wherein, in use of the fault detection system, the voltage divider (310) is coupled in parallel with a low-side switch (214, 224, 234) of a half-bridge (210, 220, 230) of the circuit (200).

3. A fault detection system according to claim 1 or claim 2, wherein the voltage divider (310) is a resistive voltage divider comprising a first resistance (312) connected in series with a second resistance (314).

4. A fault detection system according to claim 3, wherein:
the first resistance (312) comprises a plurality of resistors (312a - 312f) connected in series, and
the second resistance (314) comprises a single resistor.

5. A fault detection system according to claim 4, wherein the plurality of resistors (312a - 312f) of the first resistance (312) and the single resistor of the second resistance (314) are surface mount devices.

6. A fault detection system according to any of the preceding claims, wherein the voltage divider (310) is configured to receive an input DC voltage in the range 0 - 900 volts and to output an output DC voltage in the range 0 - 5 volts.

7. A fault detection system according to claim 6, wherein the voltage divider (310) is configured such that a magnitude of the output DC voltage is approximately 1/300^{th} of a magnitude of the input DC voltage.

8. A fault detection system according to any of the preceding claims, wherein the fault is an always-on fault.

9. A fault detection system according to any of the preceding claims, wherein the processor circuitry (320) is operative to:
compare (510) the detection signal indicative of the voltage at the output (316) of the voltage divider (310) to a first reference signal; and
responsive to a determination that the detection signal is less than the first reference signal, output (520) a first fault detection signal indicative of an always-on fault in a low-side switch of the circuit (200).

10. A fault detection system according to any of the preceding claims, wherein the processor circuitry (320) is operative to:
compare (530) the detection signal indicative of the voltage at the output (316) of the voltage divider (310) to a second reference signal; and
responsive to a determination that the detection signal is greater than the second reference signal, output (540) a second fault detection signal indicative of an always-on fault in a high-side switch of the circuit (200).

11. A fault detection system according to any of the preceding claims, wherein the circuit is an inverter circuit or a multi level converter circuit.

12. A method for detecting a fault in a switch of a half-bridge of a circuit in a transport refrigeration unit, the method comprising:
comparing (510, 530), by processor circuitry, a signal indicative of an output voltage of a voltage divider coupled in parallel with a switch of a half-bridge of the inverter to a reference voltage; and
responsive to a determination by the processor circuitry that the detected voltage does not correspond to the reference voltage, indicating (520, 540) a fault condition;
wherein the switch of the half-bridge is a second switch;
wherein a balancing impedance is coupled in parallel with a first switch of the half-bridge;
wherein an output of the voltage divider is indicative of a voltage of a node between the first switch of the half-bridge and the second switch of the half-bridge; and
wherein the balancing impedance is configured to balance the total impedance of the voltage divider.

13. A transport refrigeration system (150) comprising a circuit (200) and a fault detection system according to any of claims 1 - 11.

14. A machine-readable medium (600) having stored thereon a computer program comprising instructions which, when executed by processing means, cause the processing means to perform the method of claim 12.
